# EUROPEAN PATENT SPECIFICATION

(11) **EP 0 753 600 B1**
(45) Date of publication and mention of the grant of the patent: **09.04.2003**
(21) Application number: 96111283.6
(22) Date of filing: 12.07.1996
(51) Int. Cl.: C23C 14/34, C23C 14/22

(54) **High vacuum sputtering apparatus and a substrate to be processed**
Hochvakuum-Sputter-Vorrichtung und zu behandelndes Substrat
Dispositif de pulvérisation à vide élevé et substrat traite

(30) Priority: 14.07.1995 JP 17882295
(43) Date of publication of application: 15.01.1997
(73) Proprietor: ULVAC, INC., Chigasaki-shi, Kanagawa-Ken (JP)
(72) Inventor: Obinata, Hisaharu, c/o Fuji Susono Kojo, Susono-shi, Shizuoka-ken (JP)
(74) Representative: Sajda, Wolf E., Dipl.-Phys.

(56) References cited:
- EP-A- 0 240 369
- WO-A-89/06709
- DE-A- 3 929 695
- DE-A- 4 220 588
- GB-A- 2 058 142
- JP-A- 60 200 962
- US-A- 5 244 556

## Description

The present invention relates to a high vacuum sputtering apparatus and a substrate to be processed according to the preamble of claim 1. The technological advantages of sputtering for forming a thin film include an extensive applicability in terms of materials that can be used for the thin film, the homogeneity and uniformity of the produced film, the relative easiness with which thin film of an alloy or chemical compounds is formed, good adhesion of the produced film on a substrate, controllability, responsiveness and reproducibility of operation, and adaptability to prolonged film forming operations. In an attempt to exploit these advantages, there have been proposed various sputtering techniques, which include radio frequency sputtering and magnetron sputtering. The latter utilizes the phenomenon of magnetron discharge where an electric filed perpendicularly intersects a magnetic field. Both techniques are popularly being used.

In the trend of processing ever larger substrates, sputtering apparatuses are forced to handle larger targets and cathodes. If the substrate to be processed is a wafer with a diameter of 200 mm, the corresponding target typically has a diameter of 350 mm.

If this trend continues to process wafers with a diameter of 300 mm, targets having a diameter as large as 525 mm will have to be used. Then, such a large target may be too heavy to be handled or simply cannot be manufactured depending on the material to be used for the target. Even if it can be made, the cost may be prohibitive.

On the other hand, the distribution of film thickness obtained by sputtering may vary depending on the distribution of angles with which particles are sputtered from the target and collisions that may take place between sputtered particles and gas molecules in the sputtering apparatus. It is known that the distribution of directions with which particles are sputtered from the target usually follows a cosine curve relative a line normal to the surface of the target so that a uniform distribution of film thickness can be achieved only in an area smaller than the diameter of the target.

It is also known that the distribution of film thickness changes remarkably as a function of the distance between the target and the substrate.

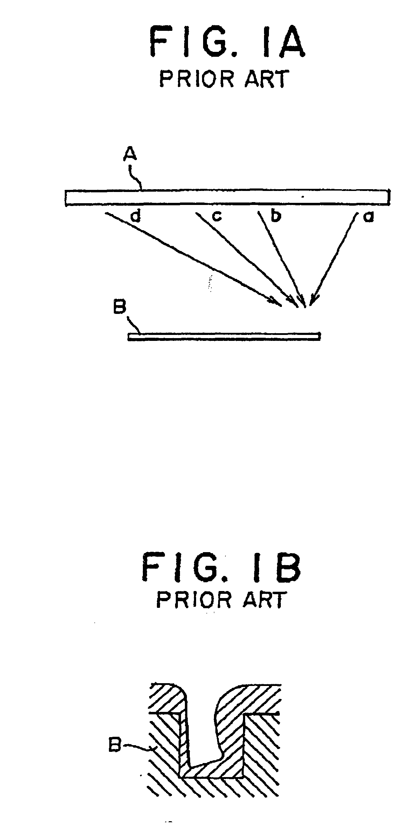

In recent years, sputtering has been used for forming a thin film inside of contact holes having a high aspect ratio. Referring to Figs. 1A and 1B of the accompanying drawings, if a target A has a smooth surface as shown in Fig. 1A, in a contact hole(s) located close to the outer periphery of a substrate B, more sputtered particles may come from areas b, c and d than from area a of the target A. As a result, the film formed in the contact hole is asymmetric both on the bottom and on the lateral wall as shown in Fig. 1B. To minimize or overcome this problem, sputtered particles have to be made to strike the substrate at an angle as close to 90° as possible in order to totally increase a bottom coverage in each of the contact holes on the entire surface of the substrate.

Techniques developed for this purpose include the one called collimation sputtering with which a slit collimator is arranged between the target and the substrate and the so-called long distance sputtering technique for providing a large gap between the target and the substrate so that only those sputtered particles that are directed perpendicularly relative to the surface of the substrate are allowed to strike the latter.

However, the former technique involves problems such as film material obstinately adhering to the slit collimator, separation of adherent film and a short service life of the collimator. Both techniques have to deal with a large target whenever a large substrate is processed.

In view of the above identified problems, there has been proposed a sputtering target that can control the directions along which particles are sputtered from it by controlling the profile of the surface of the target to improve the uniformity of thickness of the produced film (see Japanese Patent Publication No. 7-15144.)

However, the mean free path l(cm) of atoms (molecules) of gaseous substances is about 10⁻²/p(Torr) and the pressure under which the sputtering operation is conducted is about 2.6 to 6.5 x 10⁻¹ Pa (2 to 5 x 10⁻³ Torr). This results in l equal to about 2 to 5 cm. Typically the target is separated from the substrate to be processed by about 6 to 8 cm, but a longer distance has to be provided for the so-called long distance sputtering. In other words, most of the sputtered particles collide with gas atoms at least once before they get to the substrate.

Therefore, with a target designed to control the directions along which particles are sputtered, most of the particles sputtered from it change their directions after colliding with gas atoms. Thus an improvement of the distribution of film thickness and the coverage symmetry cannot be substantially achieved for the film formed in contact holes.

A high vacuum sputtering apparatus and a substrate to be processed are known from document JP-A-60-200 962 disclosing a sputtering device which is intended to form a film of a uniform thickness by sputtering on a surface of a large area. For this purpose, a target is used in that prior art which is convexly curved toward the substrate so as to inhibit film formation on the central part of the substrate and to accelerate film formation on the peripheral part thereof.

The object underlying the present invention is to provide a high vacuum sputtering apparatus and a substrate to be processed which is capable of achieving an even distribution of film thickness and producing a symmetrically arranged film in contact holes of a large substrate.

According to the invention, a high vacuum sputtering apparatus and a substrate to be processed are disclosed as specified in claim 1. With the specific geometry of the arrangement according to the invention, the desired even distribution of film thickness is achieved in a satisfying manner.

Now, the present invention will be described in more detail with reference to the accompanying drawings that illustrate preferred embodiments of the invention.
- Fig. 1A: is a schematic view showing a known flat panel type target and a substrate which are disposed to be opposite to each other;
- Fig. 1B: is an enlarged partial section view of the substrate of Fig. 1A, showing a fine hole arranged in an outer peripheral area of the substrate and the film formed in the hole;
- Fig. 2A: is a schematic view showing a preferred embodiment of a target and a substrate which are disposed to be opposite to each other;
- Fig. 2B: is an enlarged partial section view of the substrate of Fig. 2A, showing a fine hole or pore in an outer peripheral area of the substrate and the film formed in the hole;
- Fig. 3: is a schematic view showing another target;
- Fig. 4: is a schematic diagram showing a high vacuum magnetron sputtering apparatus using a target according to one embodiment; and
- Fig. 5: is an enlarged schematic section view of a fine hole arranged in a substrate, illustrating how film is formed therein.

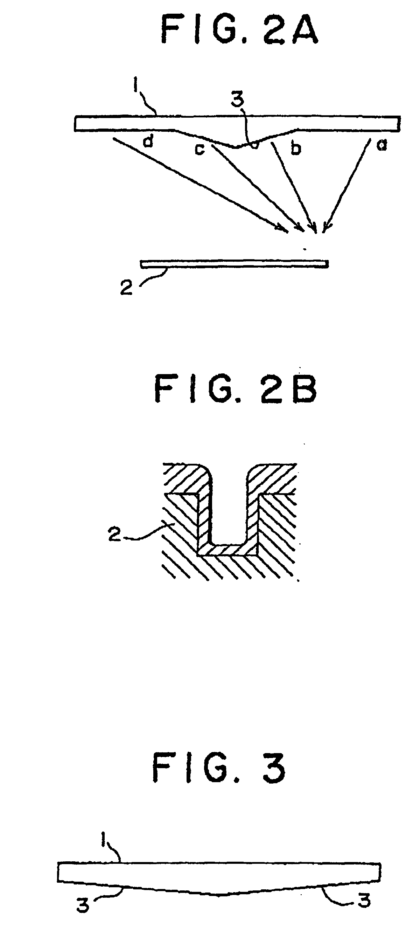

Referring to Fig. 2A there is illustrated one embodiment of a target according to the invention. The target 1 has a circular profile and its surface disposed opposite to the substrate 2 to be processed has a central raised section with an inclined surface 3 sloping down toward the outer periphery. The target 1 has a diameter less than one and half times of that of the substrate 2 to be processed. For example, if the substrate 2 has a diameter of 200 mm, the target 1 may be formed to have diameter smaller than 300 mm. If the substrate 2 has a diameter of 300 mm, the target 1 may be formed to have diameter smaller than 450 mm. The sloping angle of the inclined surface 3 of the target 1 is selected appropriately depending on the size of the target 1 and the distance separating the target 1 and the substrate 2 to be processed.

With the target 1 having a configuration as described above, a fine hole or pore provided close to the outer periphery of the substrate 2 is less exposed to particles sputtered from area c of the inclined surface 3. Additionally, it is also less exposed to particles coming from area d because the area d and the fine hole are separated from each other by a long distance. Consequently, a uniform film is formed on the bottom and the lateral wall of the hole of the substrate 2 mainly by particles coming from areas a and b as illustrated in the enlarged view of Fig. 2B.

Referring to Fig. 3 there is illustrated another target in which the inclined surface 3 is extended over the entire surface of the target 1. In other words, the surface of the target 1 is inclined from the center all the way to the outer periphery with a given angle of inclination.

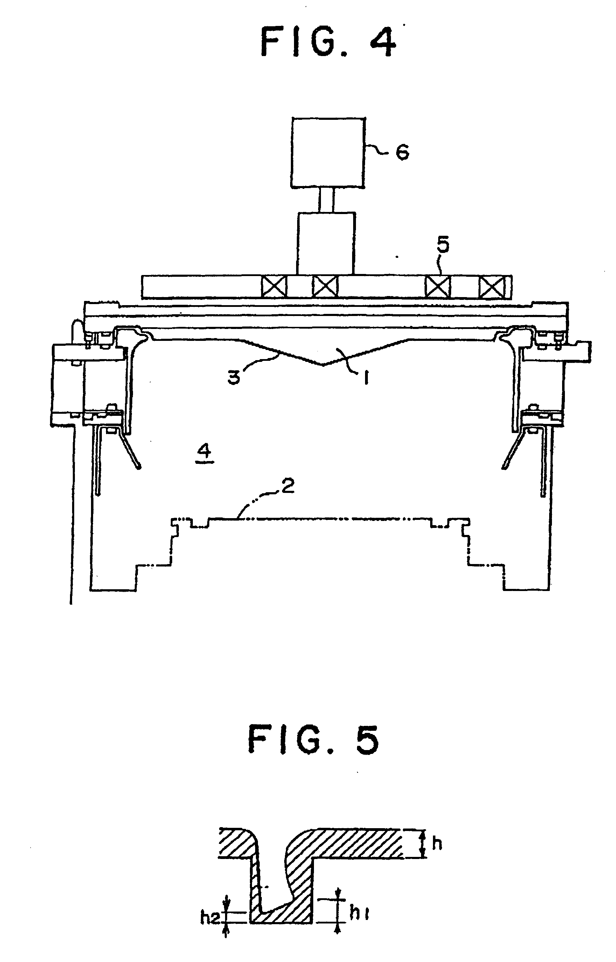

Fig. 4 illustrates schematically an embodiment of high vacuum magnetron sputtering apparatus using the target 1 as shown in Fig. 2A. In Fig. 4, reference numeral 4 denotes a vacuum chamber in which the target 1 and the substrate 2 to be processed are disposed to be opposite to each other. The internal pressure of the vacuum chamber 4 is held lower than 1.3 x 10⁻¹ Pa (1 x 10⁻³ Torr)in order to minimize the probability of collisions between the sputtered particles from the target 1 and gas atoms before the particles reach the substrate 2. Under such high vacuum conditions, the mean free path of the gas atoms (molecules) 1 exceeds 10 cm so that most of the particles sputtered from the target 1 will arrive at the substrate 2 without colliding with any gas atom (molecule).

Thus, by keeping the internal pressure of the vacuum chamber 4 containing a target 1 and a substrate 2 to be processed at a high vacuum level, the particles sputtered from the target 1 in a controlled manner can directly reach the substrate 2 without changing their respective directions on the way.

A rotary magnet 5 is arranged outside the vacuum chamber 4 on the side facing the rear surface of the target 1. The magnet 5 is driven to rotate by a motor 6 in order that erosion occurs over the entire surface of the target 1.

Although one of the above described embodiments of target has a raised central area being flat in the remaining areas, the target according to the invention may have a profile different from these embodiments.

For instance, it may have a profile with a surface inclined downward from the outer periphery toward the center.

Examples of the present invention will be now described.

A target having a raised central area as shown in Fig. 2A with a diameter of 200 mm, and a substrate with a diameter of 200 mm were arranged in a vacuum chamber with a separation distance of 80 mm. The distribution of thickness of the film formed on the substrate was observed for various internal pressure levels. The result is shown below compared to the result obtained for a conventional flat target.

| Internal pressure of vacuum chamber | Distribution of film thickness in case of flat target | Distribution of film thickness in the present invention |
|---|---|---|
| 5 x 10⁻³ Torr | ±25% | ±25% |
| 2 x 10⁻³ Torr | ±24% | ±23% |
| 1 x 10⁻³ Torr | ±20% | ±15% |
| 5 x 10⁻⁴ Torr | ±20% | ±10% |
| Note: 1x10⁻³ Torr = 1.3x10⁻¹ Pa 1x10⁻⁴ Torr = 1.3x10⁻² Pa | | |

A target having a raised central area or section as shown in Fig. 2A with a diameter of 200 mm and a substrate with a diameter of 200 mm were arranged in a vacuum chamber separated by a distance of 80 mm. The bottom coverage and symmetry of the formed film in each fine hole were observed for various internal pressure levels. The result is shown below with the result obtained for a conventional flat target.

| Internal pressure of vacuum chamber | Flat target | | Target of the embodiment | |
|---|---|---|---|---|
| | h2/h1 | h2+h1/2h | h2/h1 | h2+h1/2h |
| 5 x 10⁻³ Torr | Unmeasurably small | <0.1 | Unmeasurably small | <0.1 |
| 2 x 10⁻³ Torr | 1.5 | 0.15 | 1.5 | 0.2 |
| 1 x 10⁻³ Torr | 1.7 | 0.3 | 1.4 | 0.35 |
| 5 x 10⁻⁴ Torr | 1.9 | 0.55 | 1.3 | 0.6 |

From above, it will be seen that a good coverage ratio (h2+hl/2h) and a good symmetry value being close to 1.0 were obtained by combining high vacuum less than 1.3 x 10⁻¹ Pa (1x10⁻³ torr) and a target according to the invention.

As described above in detail, since a target according to the present invention has a diameter less than one and one-half times of that of a substrate to be processed and since the surface area is inclined downward toward the outer periphery, particles sputtered from the target can be directionally controlled when leaving the surface of the target so that the target can accommodate a large substrate.

A good distribution of film thickness and a good symmetry can be achieved for film formed on a substrate by combining the target according to the invention and the high vacuum sputtering apparatus.

## Claims

1. A high vacuum sputtering apparatus and a substrate to be processed, comprising a vacuum chamber (4), a substrate (2) provided in the vacuum chamber (4), and a sputtering target (1) provided in the vacuum chamber (4) opposite to the substrate (2),
wherein the vacuum chamber (4) is adapted to maintain an internal pressure less than 1.3 x 10⁻¹ Pa (1 x 10⁻³ torr) during sputtering,
wherein the substrate (2) to be processed in the vacuum chamber (4) has a predetermined first diameter,
wherein the sputtering target (1) has a sputtering surface with an outer periphery defining a second diameter and comprises a raised area (3) which is projecting toward the substrate (2) to be processed and is inclined toward the outer periphery of the sputtering surface of the target (1), and
wherein the inclined raised area (3) of the sputtering target (1) is located at the center of the sputtering surface,
**characterized in that** the sputtering target (1) has a second diameter which is less than one and one-half times the first diameter of the substrate (2) to be processed, and **in that** the inclined raised area (3) of the sputtering target (1) is terminated inwardly of the outer periphery of the sputtering surface of the sputtering target (1).

## Patentansprüche

1. Hochvakuum-Sputtervorrichtung und ein zu bearbeitendes Substrat, die folgendes aufweisen:
eine Vakuumkammer (4);
ein in der Vakuumkammer (4) vorgesehenes Substrat (2);
und ein Sputtertarget (1), das in der Vakuumkammer (4) vorgesehen ist und dem Substrat (2) gegenüberliegt;
wobei die Vakuumkammer (4) dazu ausgelegt ist, einen Innendruck von weniger als 1,3 x 10⁻¹ Pa (1 x 10⁻³ Torr) während des Sputterns aufrechtzuerhalten,
wobei das in der Vakuumkammer (4) zu bearbeitende Substrat (2) einen vorgegebenen ersten Durchmesser hat,
wobei das Sputtertarget (1) eine sputternde Oberfläche mit einem Außenumfang hat, der einen zweiten Durchmesser bildet und einen hochgezogenen Bereich (3) hat, der in Richtung auf das zu bearbeitende Substrats (2) vorsteht und der in Richtung des Außenumfanges der sputternden Oberfläche des Targets (1) geneigt ist, und
wobei der geneigte, hochgezogene Bereich (3) des Sputtertargets (1) in der Mitte der sputternden Oberfläche angeordnet ist,
**dadurch gekennzeichnet,**
**daß** das Sputtertarget (1) einen zweiten Durchmesser besitzt, der kleiner als das Eineinhalbfache des ersten Durchmessers des zu bearbeitenden Substrats (2) ist,
und **daß** der geneigte hochgezogene Bereich (3) des Sputtertargets (1) von dem Außenumfang der sputtemden Oberfläche des Sputtertargets (1) nach innen versetzt endet.

## Revendications

1. Dispositif de pulvérisation sous vide élevé et substrat à traiter, comprenant une chambre à vide (4), un substrat (2) prévu dans la chambre à vide (4) et une cible de pulvérisation (1) prévue dans la chambre à vide (4) à l'opposé du substrat (2),
dans lequel la chambre à vide (4) est adaptée pour maintenir une pression inteme inférieure à 1,3 x 10⁻¹ Pa (1 x 10⁻³ torr) pendant la pulvérisation,
dans lequel le substrat (2) à traiter dans la chambre à vide (4) présente un premier diamètre prédéterminé,
dans lequel la cible de pulvérisation (1) présente une surface de pulvérisation avec une périphérie exteme définissant un second diamètre, et comprend une zone en relief (3) qui fait saillie vers le substrat (2) à traiter et est inclinée vers la périphérie externe de la surface de pulvérisation de la cible (1), et
dans lequel la zone en relief inclinée (3) de la cible de pulvérisation (1) est située au centre de la surface de pulvérisation,
**caractérisé en ce que** la cible de pulvérisation (1) présente un second diamètre qui est inférieur à une fois et demie le premier diamètre du substrat (2) à traiter, et **en ce que** la zone en relief inclinée (3) de la cible de pulvérisation (1) se termine en dedans de la périphérie externe de la surface de pulvérisation de la cible de pulvérisation (1).
